**Europäisches Patentamt**

**European Patent Office**

**Office européen des brevets**

(19)

(11)     **EP 0 660 128 B1**

(12)              **FASCICULE DE BREVET EUROPEEN**

(45) Date de publication et mention
de la délivrance du brevet:
**23.07.2003   Bulletin 2003/30**

(51) Int Cl.$^7$: **G01R 33/09**

(21) Numéro de dépôt: **94402947.9**

(22) Date de dépôt: **20.12.1994**

(54) **Détecteur de champ magnétique en couches minces**

Dünnschicht Magnetfelddetektor

Thin film magnetic field detector

(84) Etats contractants désignés:
**DE GB**

(30) Priorité: **23.12.1993   FR 9315551**

(43) Date de publication de la demande:
**28.06.1995   Bulletin 1995/26**

(73) Titulaire: **Thales**
**75008 Paris (FR)**

(72) Inventeurs:
  • **Schuhl, Alain**
    **F-92402 Courbevoie Cedex (FR)**
  • **Childress, Jeffrey**
    **F-92402 Courbevoie Cedex (FR)**

(56) Documents cités:
**EP-A- 0 120 260         DE-A- 1 541 813**
**US-A- 4 179 719         US-A- 4 683 535**

  • **APPLIED PHYSICS LETTERS., vol.63, no.14, 4 Octobre 1993, NEW YORK US pages 1996 - 1998 J.R. CHILDRESS ET AL. 'New epitaxial multilayer system for spin-valve magnetic sensors'**

EP 0 660 128 B1

**Description**

L'invention concerne un capteur de champ magnétique comprenant un élément en matériau couches minces.

La réalisation d'un capteur magnétique fiable dans la gamme de champs magnétiques ≈ 10$^{-4}$ - ≈ 10 A/m (10$^{-6}$- 10$^{-1}$ Oe) reste un objectif stratégique, tant pour la détection d'anomalies magnétiques, que pour la réalisation de têtes de lecture de supports magnétiques à haute densité d'informations.

Parmi les effets physiques sensibles au champ magnétique, les phénomènes de magnétotransport présentent l'avantage de pouvoir être aisément intégrés avec l'électronique de lecture. Actuellement, deux types d'effets sont utilisés : d'une part la magnétorésistance des matériaux magnétiques, et d'autre part l'effet Hall.

On connaît de la demande de brevet allemande DE -A-1 541 813 un capteur magnétométrique utilisant l'effet Hall planaire, dans lequel la direction du courant est colinéaire avec la direction d'aimantation la plus facile.

On connaît aussi du brevet US 4,683,535 un magnétomètre à film mince parcouru par un courant dont on mesure la tension aux bornes du film et qui est soumis à une excitation magnétique extérieure à l'aide d'une bobine.

L'invention concerne un capteur de champ magnétique en utilisant l'effet connu depuis longtemps qui est appelé "effet Hall planaire".

L'invention concerne donc un capteur de champ magnétique selon les revendications annexées.

Les différents objets et caractéristiques de l'invention apparaîtront plus clairement dans la description qui va suivre et dans les figures annexées qui représentent :

- la figure 1, une vue simplifiée du dispositif de l'invention ;
- la figure 2, un exemple de réalisation détaillé avec transistor de commande ;
- la figure 3, une courbe de réponse tension/champ magnétique du dispositif selon l'invention ;
- la figure 4, une variante du dispositif de l'invention.

Il est connu que dans certains matériaux magnétiques cristallins, outre la variation angulaire de la résistance électrique, l'anisotropie de résistivité électrique se traduit par l'apparition d'une tension dans la direction perpendiculaire à la direction de circulation du courant électrique. Ainsi une mesure réalisée en géométrie de Hall donnera une tension de sortie proportionnelle à

$$\rho_H = \alpha.(\rho// - \rho^+)/2.\sin(2\theta) \qquad (1)$$

où $\alpha$ est un facteur géométrique, et $\rho//$ et $\rho^+$ sont les résistivités électriques mesurées respectivement parallèlement et perpendiculairement à l'aimantation.

Une telle mesure permet un accès direct à la valeur $\rho// - \rho^+$. Dans un capteur magnétorésistif, le rapport signal-à-bruit est limité par le bruit de la totalité de la résistance dont seulement 2 à 5 % représentent la partie utile. Dans un capteur à effet Hall planaire, seule la partie utile est mesurée.

Des études récentes menées sur des multicouches épitaxiées de Fe/Pd par Epitaxie par Jets Moléculaires (EJM), ont montré que :

- les couches sont monocristallines ;
- la symétrie cubique est clairement visible sur les cycles d'hystérésis M(H) ;
- il est possible d'induire une anisotropie uniaxiale le long d'un des deux axes faciles de la multicouche magnétique ;
- cette anisotropie se traduit par une rotation brusque de l'aimantation depuis la direction la moins facile des deux axes faciles de la couche vers l'axe le plus facile, lorsqu'un champ magnétique, appliqué le long de la direction la moins facile est progressivement réduit vers des faibles valeurs.

En outre des études par effet Kerr de la structure en domaines magnétiques de ces couches montrent clairement la possibilité d'obtenir des monodomaines magnétiques sur des tailles variant entre 1 et 100 micromètres.

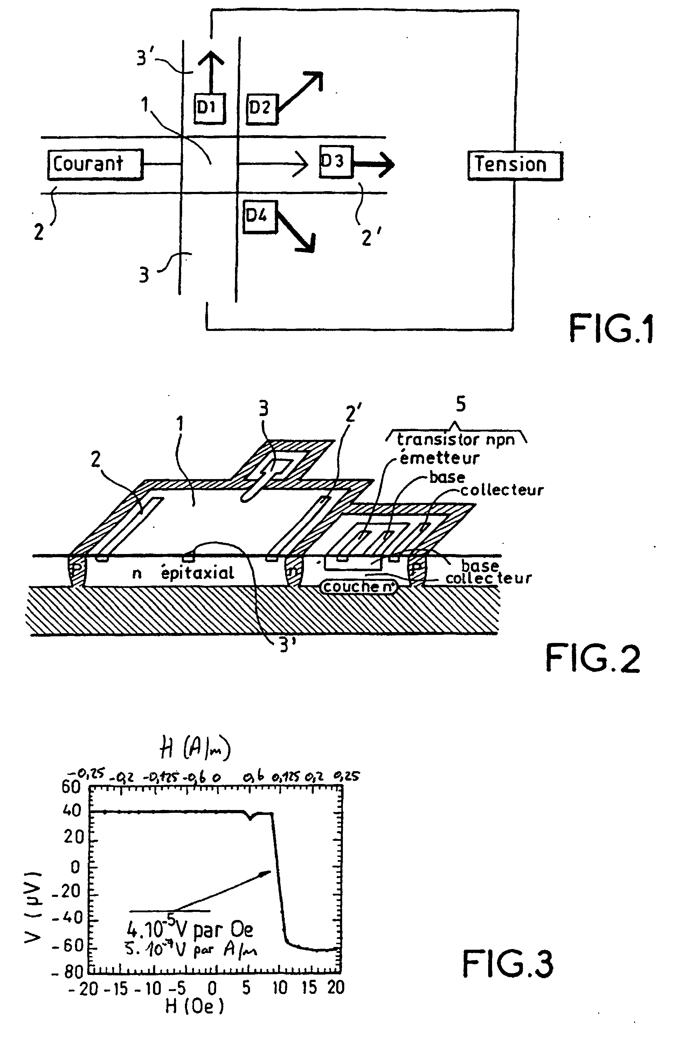

Comme cela est représenté en figure 1, le motif de base d'un capteur à effet Hall planaire a la forme d'une croix conductrice dont au moins la partie sensible centrale est en matériau à anisotropie de résistivité électrique. Le courant circule le long d'une des branches ; la direction D3 sur la figure 1. Si la partie sensible est un monodomaine à aimantation saturée, le signal de sortie dépend alors uniquement de l'angle entre l'aimantation et le courant suivant la relation (1).

Sur la figure 1, la partie sensible est représentée par la zone 1. A cette zone sont connectés deux électrodes 2 et 2' permettant la circulation d'un courant à travers cette zone selon le plan de cette zone. Deux électrodes 3, 3' sont également connectés à la zone 1 pour mesurer la tension transversalement et de préférence perpendiculairement à la direction de circulation du courant.

Cette configuration permet de s'abstraire naturellement des problèmes propres à une mesure magnétorésistive, du fait de la possibilité d'induire une anisotropie cristalline contrôlée, sur des monodomaines magnétiques monocristallins :

- une telle mesure permet un accès direct à $(\rho// - \rho^+)$. Dans un capteur magnétorésistif, le rapport signal-à-bruit est limité par le bruit de la totalité de la résistance dont seulement 2 à 5 % représentent la partie utile. Au contraire, dans un capteur à effet Hall planaire, seule la partie utile est mesurée. Il en découle une importante diminution du bruit thermique du capteur ;

- dans un capteur magnétorésistif, la dépendance en température de la composante $\rho_o$ impose d'utiliser un pont de résistances. Avec un élément à effet Hall planaire, on s'affranchit de cette complication ;

- la possibilité d'obtenir des monodomaines sur l'ensemble du capteur, permet de diminuer notablement le bruit lié aux parois de domaines ;

- pour la même raison la raideur de la variation en champ du signal de sortie est nécessairement augmentée ;

- finalement, le signal de sortie dépend peu de la taille de l'élément sensible pour peu qu'il reste carré. Avec des petites tailles, des fréquences élevées de commutation peuvent être atteintes.

Les problèmes qui ont limité le développement des capteurs à effet Hall (classique) pour la détection de champs faibles, sont eux aussi résolus. Le capteur est ici sensible à la direction de l'aimantation qui est maintenue à saturation et dans le plan, du fait de la géométrie en couche ultramince. L'effet maximum est donc obtenu sur une gamme de champ faible, de l'ordre ou inférieure à 80 A/m (1 Oe).

Il subsiste le problème propre à l'effet Hall qu'il soit planaire ou perpendiculaire. Le signal de sortie est faible (1 mv pour 1mA). Ce problème est résolu en intégrant le capteur sur un transistor 5 basse température tel que cela est représenté en figure 2.

Sur cette figure, on trouve l'élément 1 à effet Hall planaire comportant à sa surface deux électrodes 2, 2' d'amenée du courant qui sont équivalents aux conducteurs 2, 2' de la figure 1, deux autres électrodes 3, 3' également à la surface de l'élément 1.

En contrepartie, pour une puissance dissipée donnée, le bruit peut être ramené à des valeurs basses. Outre la suppression de l'offset de résistivité, le bruit lié aux mouvements des parois des domaines peut être notablement diminué. En effet, il est aisé, surtout sur des couches monocristallines d'obtenir des monodomaines magnétiques comme partie sensible. En conclusion, une fois résolu le problème de lecture d'une tension de sortie faible, la sensibilité intrinsèque des capteurs à effet Hall planaire, est nécessairement meilleure que celle des composants magnétorésistifs.

On introduit une légère anisotropie entre les deux directions de facile aimantation. Cela est réalisable de manière contrôlée, en agissant par exemple sur les conditions de dépôt : en introduisant un angle entre la direction d'arrivée des atomes et la normale au substrat, ou en déposant sous champ magnétique. Supposons que la plus facile des directions faciles soit la direction D4, définie sur la figure 1. Le système sera alors utilisé pour mesurer un champ dirigé suivant la direction D2. En effet, à champ élevé, l'aimantation pointe le long de l'axe D2. Lorsque le champ diminue, il arrive à être plus faible que l'anisotropie entre les directions D2 et D4. L'aimantation tourne alors de 90°. La rotation est brusque et se traduit par une rapide inversion du signal de sortie, comme l'atteste les résultats ci-dessus obtenus sur une multicouche à base de Fe/Pd/Co/Cu. La forte pente permet une grande sensibilité.

La figure 3 représente la réponse tension/ champ magnétique d'un élément Hall planaire de 0,5 mm de côté. Le matériau est une multicouche à base de Fe/Pd/Co/Cu épaisse de 30 nm. Pour un signal de sortie de 0,1 mV, le courant est de 1mA, ce qui correspond à une puissance dissipée de 2mWatts. Des couches monocristallines de Permalloy donnent des tensions de sortie de l'ordre du mV.

En contrepartie, pour une puissance dissipée donnée, le bruit peut être ramené à des valeurs basses. Outre la suppression de l'offset de résistivité, le bruit lié aux mouvements des parois des domaines peut être notablement diminué. En effet, il est aisé surtout sur des couches monocristallines d'obtenir des monodomaines magnétiques comme partie sensible. En conclusion, une fois résolu le problème de lecture d'une tension de sortie faible, la sensibilité intrinsèque des capteurs à effet Hall planaire, est nécessairement meilleure que celle des composants magnétorésistifs.

En couplant sur la même plaquette deux capteurs mesurant deux composantes orthogonales dans le plan et un capteur à effet Hall planaire, il est possible de réaliser une boussole permettant la détermination à 3D de la direction du champ.

Le dispositif de l'invention peut également être appliqué à la lecture de supports d'enregistrement magnétique tels qu'une bande magnétique.

Sur une bande magnétique, les informations sont digitalisées en utilisant deux directions opposées à l'aimantation. La lecture se réduit en fait à la détermination du signal de l'aimantation successivement sur chaque bit. L'utilisation de l'effet Hall planaire est assez simple. On considère un matériau à symétrie cubique, dont les axes de facile aimantation sont placés suivant les axes D2 et D4. Le courant circule suivant la direction D3. Un champ statique $H_b$ faible est orienté par exemple dans la direction D3. Le champ produit par le moment correspondant à un bit pointe selon la direction D1, en pointant dans un sens ou dans l'autre. L'aimantation du domaine sensible pointe alors soit dans la direction D2 soit dans la direction D4. Cela donne la sensibilité maximale à l'effet, puisque entre un bit "0" et un bit "1" le signal de sortie passe de $l.(\rho// - \rho^+)/2e$ à $l.(\rho// - \rho+)/2e$.

Le champ $H_b$ a pour rôle de forcer l'aimantation à avoir une composante pointant dans le sens du courant. Il doit seulement être plus faible que l'anisotropie magnétocristalline. A l'inverse d'un champ de bias, sa valeur précise n'est pas capitale.

La réalisation d'une matrice d'éléments Hall planaire ne pose pas de problèmes à priori.

La conception de matériaux magnétiques constitués de couches magnétiques, séparées par des couches d'un matériau non-magnétique, a relancé l'intérêt de ce type de capteurs. Des variations de résistivités proches de 100 % ont été obtenues. Cette forte magnétorésistance observée notamment dans les multicouches Fe/Cr est due à la transition sous champ magnétique entre les deux états d'aimantation du système, à savoir l'état ou l'alternance des aimantations des couches magnétiques est anti-parallèle et l'état où toutes ces aimantations sont parallèles.

Le principal inconvénient de cet effet reste la haute valeur du champ magnétique $H_s$ nécessaire pour faire transiter les aimantations de l'état parallèle à l'état anti-parallèle.

Des nouvelles structures de multicouches pour lesquelles l'alignement antiferromagnétique est obtenu sans couplage entre les couches magnétiques conduisent à des rotations à bas champ de l'aimantation et donc à des sensibilités importantes (jusqu'à 2 % pour 80 At/m (1 Oe)). Cependant dans ces structures l'effet magnétorésistif est réduit à moins de 10 %.

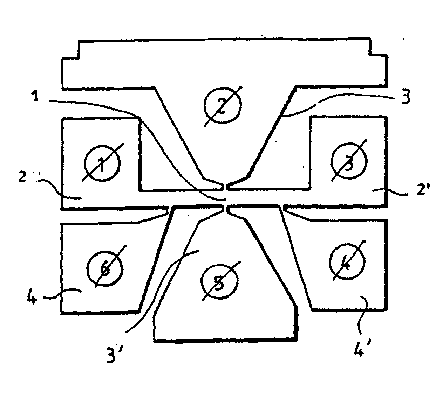

La figure 4 représente une variante de réalisation du dispositif de l'invention où l'on retrouve l'élément à effet Hall 1 sous forme d'un ruban 1 avec les électrodes 2, 2' d'amenée du courant, et les électrodes 3, 3' pour la mesure du courant perpendiculairement à la direction de circulation du courant. En plus, deux électrodes 4, 4' connectées à peu près au même niveau que les électrodes 2, 2' permettent de mesurer la différence de potentiel le long du ruban et donc de mesurer la tension de magnétorésistance. Cette structure permet donc de mesurer le bruit thermique.

Cette structure permet en outre d'injecter une contre-réaction par les électrodes 4, 4' pour diminuer l'effet du bruit thermique.

A titre d'exemple, la largeur du ruban constituant l'élément est comprise entre 100 et 500 μm (par exemple 200 μm). Les connexions des électrodes 3, 3' à l'élément 1 sont larges de 10 à 50 μm (20 μm par exemple).

Les couches déposées présentent une anisotropie magnétocristalline complexe. D'une part, les axes de faciles aimantations (Fac) sont dirigés suivant les directions (100) du Fer, c'est-à-dire les directions (110) du substrat. Comme les axes de clivage du substrat sont les axes (100), les directions de facile aimantation sont le long des diagonales du carré de MgO. D'autre part, une des deux directions de facile aimantation (Fac+) est légèrement plus facile que l'autre (Fac-).

Si on considère que le courant circule le long d'un axe de difficile aimantation, c'est-à-dire entre les axes (Fac+) et (Fac-), à 45° des deux, lorsque l'aimantation passe d'une direction à l'autre le signal d'effet Hall planaire change de signe.

Lorsqu'on applique un champ magnétique dans la direction (Fac-). Lorsque le champ décroît, il arrive un moment où l'aimantation se place dans la direction la plus facile (Fac+). Puis à champ négatif, l'aimantation retourne dans la direction (Fac-).

## Revendications

1. Capteur de champ magnétique **caractérisé en ce qu'**il comprend un élément (1) en matériau couches minces magnétorésistives cristallines à anisotropie de résistivité dans le plan, possédant également dans ce plan deux axes d'aimantation faciles de valeurs différentes, cet élément comportant deux électrodes (2, 2') permettant la circulation d'un courant dans l'élément selon une première direction non colinéaire avec aucun des axes d'aimantation et deux électrodes (3, 3') permettant une mesure de tension selon une deuxième direction transverse par rapport à la première direction.

2. Capteur de champ magnétique selon la revendication 1, **caractérisé en ce que** l'élément magnétorésistif a la forme d'un ruban et est alimenté en courant par circulation d'un courant selon la plus grande longueur du ruban et que les électrodes sont situés en deux points situés sur les bords latéraux du ruban.

3. Capteur de champ magnétique selon la revendication 2, **caractérisé en ce que** la section des électrodes sur les bords du ruban sont inférieures ou de l'ordre du dixième de la section du ruban.

4. Capteur de champ magnétique selon la revendication 2, **caractérisé en ce que** la largeur du ruban est de l'ordre de quelques centaines de micromètres et la largeur des électrodes sur le ruban de l'ordre de quelques dizaines de micromètres.

5. Capteur de champ magnétique selon la revendication 1, **caractérisé en ce que** l'élément en matériau couche mince magnétorésistive est un multicouche métallique magnétique.

6. Capteur de champ magnétique selon la revendication 1, **caractérisé en ce que** l'élément en matériau magnétorésistif a une forme rectangulaire ou carrée qui prolonge par des rubans conducteurs connectés aux côtés du rectangle ou du carré, l'ensemble ayant la forme d'une croix.

7. Capteur de champ magnétique selon la revendication 1, **caractérisé en ce que** la direction du courant est dirigée selon la bissectrice de l'angle formé par les deux directions faciles d'aimantation.

8. Procédé d'utilisation d'un capteur selon la revendication 1, **caractérisé en ce que** le champ magnétique à mesurer est orienté dans le plan de la couche magnétorésistive.

9. Procédé d'utilisation d'un capteur selon la revendication 1, **caractérisé en ce que** les deux axes d'aimantation sont perpendiculaires et que le champ magnétique à mesurer est placé perpendiculairement à la direction d'aimantations la plus facile.

**Patentansprüche**

1. Magnetfeldsonde, **dadurch gekennzeichnet, daß** ein Element (1) aus einem dünnen magnetoresistiven Kristalschichtenmaterial mit einer Widerstandsanisotropie in der Ebene enthält, das außerdem in dieser Ebene zwei Achsen leichter Magnetisierung unterschiedlicher Werte besitzt, wobei das Element zwei Elektroden (2, 2') besitzt, die einen Strom in dem Element gemäß einer ersten Richtung fließen lassen, die mit keiner der Magnetisierungsrichtungen kolinear ist, und zwei Elektroden (3, 3'), die eine Messung der Spannung gemäß einer zweiten Richtung erlauben, die quer bezüglich der ersten Richtung verläuft.

2. Magnetfeldsonde nach Anspruch 1, **dadurch gekennzeichnet, daß** das magnetoresistive Element die Form eines Bands hat und mit Strom gemäß der größten Ausdehnung des Bands gespeist wird und daß die Elektroden an zwei Punkten an den Rändern des Bands liegen.

3. Magnetfeldsonde nach Anspruch 2, **dadurch gekennzeichnet, daß** der Querschnitt der Elektroden an den Rändern des Bands kleiner oder höchstens gleich einem Zehntel des Querschnitts des Bands ist.

4. Magnetfeldsonde nach Anspruch 2, **dadurch gekennzeichnet, daß** die Breite des Bands etwa einige hundert Mikrometer und die Breite der Elektroden am Band etwa einige zehn Mikrometer beträgt.

5. Magnetfeldsonde nach Anspruch 1, **dadurch gekennzeichnet, daß** das Element aus einem magnetoresistiven Dünnschichtmaterial eine metallische, magnetische Mehrschichtstruktur ist.

6. Magnetfeldsonde nach Anspruch 1, **dadurch gekennzeichnet, daß** das Element aus magnetoresistivem Material eine rechteckige oder quadratische Form aufweist, die durch leitende Bänder verlängert ist, die an den Seiten des Rechtecks oder Quadrats angeschlossen sind, sodaß das ganze die Form eines Kreuzes annimmt.

7. Magnetfeldsonde nach Anspruch 1, **dadurch gekennzeichnet, daß** der Strom entlang der Winkelhalbierenden des von den beiden Richtungen leichter Magnetisierung gebildeten Winkels fließt.

8. Verfahren zur Verwendung der Sonde nach Anspruch 1, **dadurch gekennzeichnet, daß** das zu messende Magnetfeld in der Ebene der magnetoresistiven Schicht ausgerichtet ist.

9. Verfahren zur Verwendung einer Sonde nach Anspruch 1, **dadurch gekennzeichnet, daß** die beiden Magnetisierungsachsen senkrecht aufeinander stehen und daß das zu messende Magnetfeld senkrecht zur Richtung der leichtesten Magnetisierung ausgerichtet ist.

**Claims**

1. Magnetic field sensor **characterized in that** it comprises an element (1) made of a crystalline magnetoresistive thin-film multilayer material with anisotropy of resistivity in the plane, also having in this plane two easy axes of magnetization of different values, this element comprising two electrodes (2, 2') allowing a current to flow in the element in a first direction which is not collinear with any of the magnetization axes and two electrodes (3, 3') allowing a voltage to be measured in a second direction transverse to the first direction.

2. Magnetic field sensor according to Claim 1, **characterized in that** the magnetoresistive element is in the shape of a strip and is supplied with current by flow of a current in the direction of the greatest length of the strip and **in that** the electrodes are located at two points positioned on the side edges of the strip.

3. Magnetic field sensor according to Claim 2, **characterized in that** the section of the electrodes on the edges of the strip is less than or about one-tenth of the section of the strip.

4. Magnetic field sensor according to Claim 2, **characterized in that** the width of the strip is of the order of a few hundred micrometres and the width of the electrodes on the strip is of the order of a few tens of micrometres.

5. Magnetic field sensor according to Claim 1, **characterized in that** the element made of a magnetoresistive thin-film material is a magnetic metallic multilayer.

6. Magnetic field sensor according to Claim 1, **characterized in that** the element made of a magnetoresistive material has a rectangular or square shape that is extended by conductive strips connected to the sides of the rectangle or of the square, the entire unit having the shape of a cross.

7. Magnetic field sensor according to Claim 1, **characterized in that** the current is directed along the bisector of the angle formed by the two easy magnetization directions.

8. Method of using a sensor according to Claim 1, **characterized in that** the magnetic field to be measured is oriented in the plane of the magnetoresistive layer.

9. Method of using a sensor according to Claim 1, **characterized in that** the two magnetization axes are perpendicular and **in that** the magnetic field to be measured is placed perpendicular to the easiest magnetization direction.

3'

D1

1

D2

Courant

→ D3 →

Tension

2

D4

3

2'

## FIG.1

2

1

3

2'

5

transistor npn

émetteur

base

collecteur

n épitaxial

base
collecteur

couche n

3'

## FIG.2

H (A/m)

-0,25 -0,2 -0,125 -0,6 0   0,6 0,125 0,2 0,25

60

40

20

0

V (µV)

-20

-40

$4.10^{-5}$ V par Oe

$5.10^{-7}$ V par A/m

-60

-80

-20 -15 -10 -5  0  5  10 15 20

H (Oe)

## FIG.3